# EUROPÄISCHE PATENTSCHRIFT

(11) **EP 2 616 831 B1**
(45) Veröffentlichungstag und Bekanntmachung des Hinweises auf die Patenterteilung: **07.03.2018**
(21) Anmeldenummer: 11758142.1
(22) Anmeldetag: 17.08.2011
(51) Int. Cl.: H01R 103/00, G01R 3/00, H01R 24/42, G01R 35/00, H01R 13/646, H01R 24/40, H01P 1/24

(54) **KALIBRIEREINHEIT FÜR EIN MESSGERÄT**
CALIBRATION UNIT FOR A MEASURING DEVICE
UNITÉ D'ÉTALONNAGE POUR UN APPAREIL DE MESURE

(30) Priorität: 17.09.2010 DE 102010045780
(43) Veröffentlichungstag der Anmeldung: 24.07.2013
(73) Patentinhaber: Rohde & Schwarz GmbH & Co. KG, 81671 München (DE)
(72) Erfinder: HECHTFISCHER, Gerd, 85591 Vaterstetten (DE); HOHENESTER, Wilhelm, 81543 München (DE); HUBER, Rupert, 84405 Dorfen (DE); JÜNEMANN, Ralf, 81735 München (DE); PINTA, Christian, 80637 München (DE); VÖLK, Monika, 81541 München (DE)
(74) Vertreter: Körfer, Thomas
(86) Internationale Anmeldenummer: PCT/EP2011/064121
(87) Internationale Veröffentlichungsnummer: WO 2012/034803

(56) Entgegenhaltungen:
- WO-A1-2004/023596
- WO-A1-2006/021280
- DE-A1- 2 042 821
- US-A- 4 797 642
- US-A- 5 047 737

## Beschreibung

Die Erfindung betrifft eine Kalibriereinheit für ein elektronisches Messgerät, insbesondere für einen Netzwerkanalysator.

Netzwerkanalysatoren, die zum Bestimmen von Streuparametern von angeschlossenen Messobjekten, wie z.B. von Filtern, Verstärkern und Dämpfungsgliedern dienen, decken einen weiten Frequenzbereich ab und erreichen immer höhere obere Grenzfrequenzen. Über spezielle Aufwärtsmischstufen können die Streuparameter von Messobjekten z.B. im W-Band (75 GHz bis 110 GHz) ermittelt werden. Die einzelnen Komponenten eines Netzwerkanalysators sind dabei selbst fehlerbehaftet und weisen einen Frequenz- und Phasengang auf, der insbesondere bei hohen Frequenzen dazu führt, dass keine genauen Aussagen vom Messobjekt mehr möglich sind. Eine Kalibrierung des Netzwerkanalysators erlaubt dabei diese Systemfehler zu kompensieren, wodurch die Messgenauigkeit stark erhöht wird.

Eine solche Kalibrierung erfolgt dadurch, dass nacheinander verschiedene Kalibrierstandards mit bekannten elektrischen Eigenschaften an den Messtoren angeschlossen werden und die Messwerte ermittelt werden. Bekannte Kalibrierstandards sind Leerlauf (engl. open), Kurzschluss (engl. short), Abschluss (engl. match) und Durchverbindung (engl. through). Dabei muss z.B. der Kalibrierstandard Abschluss über einen möglichst weiten Frequenzbereich eine möglichst hohe Signaldämpfung erreichen, so dass eine gute Unterscheidbarkeit z.B. zwischen dem Kalibrierstandard Abschluss von dem Kalibrierstandard Kurzschluss gewährleistet ist. Die Kalibrierstandards Leerlauf, Kurschluss und Abschluss liegen dabei als koaxiale Steckverbinder vor, die nacheinander auf die einzelnen koaxialen Messtore des Netzwerkanalysators geschraubt werden. Um Signale mit Frequenzen bis hin zu 110 GHz über eine koaxiale Verbindung übertragen zu können, werden koaxiale Leitungen verwendet, deren Außenleiterdurchmesser 1 mm und deren Innenleiterdurchmesser 0,434 mm betragen. Die als koaxiale Steckverbinder ausgeführten Kalibrierstandards müssen daher entsprechend filigran und gleichzeitig mechanisch stabil gefertigt sein, denn bereits Abweichungen von 0,005 mm im Außenleiterdurchmesser führen dazu, dass sich der Wellenwiderstand um ca. 0,7 Ohm ändert, wodurch keine hoch genauen Messungen mehr möglich sind.

Aus der US 5,047,737 A ist ein Abschluss für ein koaxiales Leitungssystem bekannt. Ein Innenleiter besitzt eine Nut, welche zur Aufnahme eines Substrats dient. Das Substrat ist mit einem Dünnschichtwiderstand überzogen, der mit Hilfe einer Lötverbindung mit dem Innenleiter kontaktiert wird. Der Dünnschichtwiderstand verbindet den Innenleiter mit dem Gehäuse. Die Bohrung innerhalb des Gehäuses ist dabei zum Ende hin getapert. Nachteilig an der US 5,047,737 A ist, dass der Übergang vom Innenleiter auf das Substrat eine nicht unerhebliche Störung des elektromagnetischen Feldes darstellt und damit die Effizienz des Dämpfungsglieds reduziert.

Aus der WO2006/021280 ist ein koaxialer Kalibrierstandard bekannt.

Es ist daher die Aufgabe der Erfindung eine Kalibriereinheit, die einerseits mechanisch stabil ist und andererseits auch bei sehr hohen Frequenzen optimale Eigenschaften erzielt, und ein entsprechendes Herstellungsverfahren zu schaffen.

Die Aufgabe wird bezüglich der Kalibriereinheit durch die Merkmale des Anspruchs 1 und bezüglich des Verfahrens durch die Merkmale des Anspruchs 12 gelöst. In den Unteransprüchen sind vorteilhafte Weiterbildungen der erfindungsgemäßen Kalibriereinheit und des erfindungsgemäßen Verfahrens angegeben.

Die erfindungsgemäße Kalibriereinheit für ein Messgerät zum Verbinden mit einer koaxial ausgeführten Steckverbindung weist ein Gehäuse und einen Innenleiter auf, wobei der Innenleiter zentriert innerhalb einer Öffnung des Gehäuses ausgebildet ist. Die Kalibriereinheit weist weiterhin ein Verbindungselement auf, wobei das Verbindungselement in die Öffnung des Gehäuses einführbar ist und den Innenleiter aufnimmt und wobei das Verbindungselement elastisch ausgeführt ist und den Innenleiter gegenüber dem Gehäuse abstützt.

Besonders vorteilhaft ist es, dass ein elastisches Verbindungselement in die Öffnung des Gehäuses der Kalibriereinheit einführbar ist und den Innenleiter aufnimmt. Dadurch wird erreicht, dass der Innenleiter besonders gut zentriert ist und immer denselben Abstand zum Außenleiter aufweist, so dass sich der Wellenwiderstand der Kalibrierschaltung über den Frequenzbereich kaum ändert. Durch die elastische Ausbildung des Verbindungselements ist sichergestellt, dass die mechanische Integrität der Kalibriereinheit durch mehrfaches Verschrauben mit der zu kalibrierenden Messeinheit nicht beeinträchtigt ist, auch wenn die Kalibriereinheit nicht auf einem Schlitten befestigt einzig in horizontaler Achse auf die zu kalibrierende Messeinheit zu bewegt wird. Das elastische Verbindungselement dämpft auch kleinere Erschütterungen, die z.B. durch das versehentliche Fallenlassen der Kalibriereinheit entstehen.

In einem ersten Verfahrensschritt des erfindungsgemäßen Verfahrens zur Herstellung der Kalibriereinheit wird ein Formstempel, welcher eine Negativform eines Verbindungselements hat, galvanisiert, so dass dabei das Verbindungselement entsteht. In einem zweiten Verfahrensschritt wird das galvanisierte Verbindungselement durch Wegätzen des Formstempels oder durch Abziehen des Verbindungselements von dem Formstempel herausgelöst.

Es ist besonders vorteilhaft, dass bei dem erfindungsgemäßen Verfahren das elastische Verbindungselement durch einen Galvanisierungsprozess hergestellt wird, weil dadurch die Schichtdicke und damit auch die Federrate sehr genau den Erfordernissen entsprechend eingestellt werden kann. Weiterhin ist es von Vorteil, dass der Formstempel durch Ätzten von dem Verbindungselement getrennt wird, weil dadurch das Verbindungselement in seiner Struktur selbst erhalten bleibt.

Ein weiterer Vorteil der erfindungsgemäßen Kalibriereinheit besteht, wenn das Verbindungselement trichterförmig ausgebildet ist und mehrere zusammenhängende Teilsegmente umfasst. Die trichterförmige Ausbildung mit einem sich in seinem Durchmesser verändernden Segment, sorgt dafür, dass die Kalibriereinheit über einen sehr weiten Frequenzbereich optimale Eigenschaften aufweist. Die verschiedenen Teilsegmente des Verbindungselements sind unterschiedlich ausgebildet und dienen z.B. der Befestigung des Verbindungselements am Gehäuse oder zur Aufnahme des Innenleiters durch das Verbindungselement.

Außerdem besteht ein Vorteil der erfindungsgemäßen Kalibriereinheit, wenn ein erstes Teilsegment des Verbindungselements als Flansch oder Haube ausgebildet ist und mit dem Gehäuse elektrisch leitend verklebt und/oder verpresst und/oder verlötet ist. Ein als Flansch oder Haube ausgebildetes erstes Teilsegment des Verbindungselements, welches sich über die Öffnung des Gehäuses legt, stellt sicher, dass das Verbindungselement nicht innerhalb der Öffnung des Gehäuses verkantet, sondern immer in optimaler Ausrichtung montiert werden kann. Dadurch, dass das Verbindungselement mit dem Gehäuse verklebt und/oder verpresst und/oder verlötet wird, ist sichergestellt, dass sich das Verbindungselement auch im Laufe der Zeit nicht löst und somit der vom Verbindungselement aufgenommene Innenleiter dauerhaft in seiner Position fixiert ist.

Schlussendlich besteht ein Vorteil der erfindungsgemäßen Kalibriereinheit, wenn der Innenleiter im Falle der Lastzustände Leerlauf und Abschluss aus zumindest zwei Teilsegmenten besteht, wobei ein zweites Teilsegment aus einem Dielektrikum besteht, welches im Falle des Lastzustands Abschluss abschnittsweise mit einem Dünnschichtwiderstand oder Dickschichtwiderstand und einem elektrisch leitfähigen Material überzogen ist. Dies erlaubt, dass die Kalibriereinheit einerseits die Kalibrierstandards Kurzschluss und Leerlauf abdeckt und andererseits auch mittels des Dünnschichtwiderstands oder Dickschichtwiderstands für den Kalibrierstandard Abschluss verwendbar ist. Der Dünnschichtwiderstand oder der Dickschichtwiderstand ist für gewöhnlich derart gewählt, dass die Kalibriereinheit einen Widerstand von 50 Ohm über einen möglichst weiten Frequenzbereich bis hin zu 110 GHz möglichst genau erreicht.

Bei dem erfindungsgemäßen Verfahren zur Herstellung der Kalibriereinheit besteht weiterhin ein Vorteil, wenn der Innenleiter oder ein erstes Segment des Innenleiters in einem Drehprozess hergestellt und mit einem sehr gut leitfähigen Material galvanisiert und/oder besputtert wird. Anhand dieser weiteren Verfahrensschritte kann der Innenleiter sehr genau hergestellt werden, so dass sich der Wellenwiderstand nicht ändert. Drehprozesse erlauben eine Genauigkeit von wenigen Mikrometern.

Ferner besteht bei dem erfindungsgemäßen Verfahren zur Herstellung der Kalibriereinheit ein Vorteil, wenn ein zweites Segment des Innenleiters mit dieelektrischen Eigenschaften durch einen Pressprozess und/oder Sinterprozess und/oder Drehprozess hergestellt wird und wenn auf das zweite Segment abschnittsweise ein Dünnschichtwiderstand oder Dickschichtwiderstand und eine elektrisch leitfähige Schicht aufgetragen wird und wenn anschließend der Dünnschichtwiderstand oder der Dickschichtwiderstand mittels eines Lasers getrimmt werden und wenn das zweite Segment des Innenleiters mittels eines Lötprozesses und/oder Klebeprozesses mit einem ersten Segment des Innenleiters verbunden wird. Dies erlaubt die Herstellung einer Kalibriereinheit für den Kalibrierstandard Abschluss, wobei der Dünnschichtwiderstand derart gewählt wird, dass die Kalibriereinheit möglichst genau einen Widerstandstand von z.B. 50 Ohm darstellt.

Schlussendlich besteht bei dem erfindungsgemäßen Verfahren zur Herstellung einer Kalibriereinheit ein Vorteil, wenn der Innenleiter oder das erste Teilsegment und das zweite Teilsegment des Innenleiters in das Verbindungselement geschoben wird, so dass anschließend das Verbindungselement in die Öffnung des Gehäuses eingeführt und mit dem Gehäuse verlötet oder verklebt werden kann. Eine derartige Ausgestaltung des Verbindungselements erlaubt eine sehr einfache Montage, wobei das Verbindungselement dabei auch für Kalibriereinheiten verwendet werden kann, die die Kalibrierstandards Leerlauf und Kurzschluss abdecken. Beim Kalibrierstandard Leerlauf wird das zweite Segment des Innenleiters nicht mit dem Dünnschichtwiderstand beschichtet und beim Kalibrierstandard Kurzschluss besteht das zweite Segment des Innenleiters aus einem Metall oder ist mit einer metallischen Schicht überzogen.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:
- Fig. 1: einen Schnitt entlang einer Längsachse durch ein erfindungsgemäßes Ausführungsbeispiel der Kalibriereinheit;
- Fig. 2A: einen Schnitt entlang der Längsachse durch ein erfindungsgemäßes Ausführungsbeispiel des Verbindungselements;
- Fig. 2B: einen Schnitt entlang der Längsachse durch einen Formstempel eines Ausführungsbeispiels des erfindungsgemäßen Verbindungselements;
- Fig. 3: einen Schnitt entlang der Längsachse durch ein Ausführungsbeispiel des erfindungsgemäßen Verbindungselements in einer perspektivischen Ansicht;
- Fig. 4A: eine räumliche Darstellung eines Ausführungsbeispiels eines erfindungsgemäßen Innenleiters mit einem Kontaktstecker;
- Fig. 4B: eine räumliche Darstellung eines Ausführungsbeispiels eines erfindungsgemäßen Innenleiters mit einer Kontaktbuchse;
- Fig. 5A: eine räumliche Darstellung eines Ausführungsbeispiels eines erfindungsgemäßen Innenleiters, wie er für den Kalibrierstandard Kurzschluss verwendet werden kann;
- Fig. 5B: eine räumliche Darstellung eines Ausführungsbeispiels eines erfindungsgemäßen Innenleiters, wie er für den Kalibrierstandard Abschluss verwendet werden kann;
- Fig. 5C: eine räumliche Darstellung eines Ausführungsbeispiels eines erfindungsgemäßen Innenleiters, wie er für den Kalibrierstandard Leerlauf verwendet werden kann;
- Fig. 6: eine räumliche Darstellung eines Ausführungsbeispiels der erfindungsgemäßen Kalibriereinheit im montierten Zustand;
- Fig. 7: eine geschnittene räumliche Darstellung eines Ausführungsbeispiels der erfindungsgemäßen Kalibriereinheit entlang der Längsachse;
- Fig. 8: den S11-Parameter über die Frequenz aufgetragen für ein Ausführungsbeispiel der erfindungsgemäßen Kalibriereinheit; und
- Fig. 9: ein Ausführungsbeispiel für ein Flussdiagramm für die Herstellung der erfindungsgemäßen Kalibriereinheit.

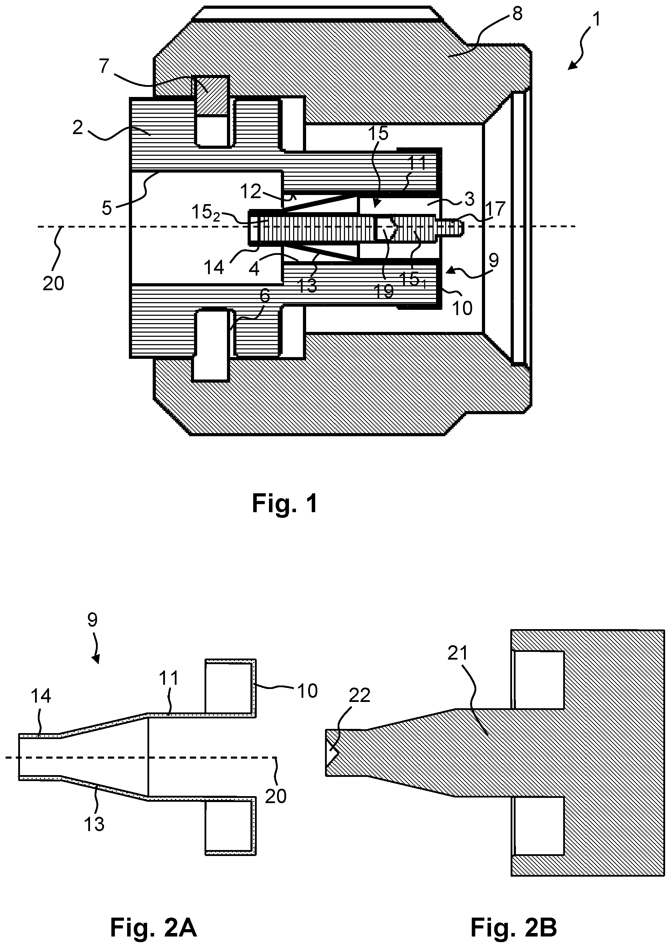

Fig. 1 zeigt einen Schnitt entlang einer Längsachse 20 durch ein erfindungsgemäßes Ausführungsbeispiel der Kalibriereinheit 1. Die Kalibriereinheit 1 wird mit einem Messgerät, bei welchem es sich bevorzugt um einen Netzwerkanalysator handelt, verbunden. Dabei ist die Kalibriereinheit 1 als koaxial ausgeführte Steckverbindung ausgebildet und kann bei einem Frequenzbereich von bis zu 110 GHz einen Außenleiter mit einem Außenleiterdurchmesser von 1 mm aufnehmen. Die Kalibriereinheit 1 umfasst ein Gehäuse 2, welches elektrisch leitfähig ist oder zumindest mit einer sehr gut elektrisch leitfähigen Schicht überzogen ist. Bevorzugt wird das Gehäuse 2 mit einer Goldschicht in einem Galvanisierungsprozess überzogen. Abhängig von der Gehäuseform kann das Gehäuse 2 auch in einem Sputterprozess mit der leitfähigen Schicht überzogen werden. Das Gehäuse 2 ist in dem erfindungsgemäßen Ausführungsbeispiel aus Fig. 1 als Hohlzylinder ausgebildet und weist eine Öffnung 3 auf. Die Öffnung 3 entsteht dabei bevorzugt durch einen Bohrprozess, wobei ein erster Bohrradius 4 am aufnahmeseitigen Ende des Gehäuses 2 bevorzugt kleiner gewählt ist, als ein zweiter Bohrradius 5 an dem aufnahmeseitigen Ende entgegengesetzten zweiten Ende des Gehäuses 2. Der Außendurchmesser des Gehäuses 2 ist am aufnahmeseitigen Ende ebenfalls kleiner als an dem zweiten Ende des Gehäuses 2.

An dem zweiten Ende des Gehäuses 2 ist eine Nut 6 ausgebildet, die in einem Drehprozess herstellbar ist. In die Nut 6 wird ein Sprengring 7 eingeführt, an dem ein Überwurf 8 befestigt ist, so dass der Überwurf 8 beweglich am Gehäuse 2 gehalten wird. Der Überwurf 8 weist an dem anschlussseitigen Ende des Gehäuses 2 ein Gewinde auf, mit dessen Hilfe die Kalibriereinheit 1 fest an einem Anschlusstor des Netzwerkanalysators verschraubbar ist. Weiterhin weist die Kalibriereinheit 1 ein Verbindungselement 9 auf, wobei das Verbindungselement 9 bevorzugt in die Öffnung 3 des anschlussseitigen Endes des Gehäuses 2 einführbar ist. Das Verbindungselement 9 ist bevorzugt trichterförmig ausgebildet und umfasst mehrere zusammenhängende Teilsegmente. Ein erstes Teilsegment 10 des Verbindungselements 9 ist als Flansch oder Haube ausgebildet und mit dem anschlussseitigen Ende des Gehäuses 2 verklebt und/oder verpresst und/oder verlötet. Weil ein Radius des ersten Teilsegments 10 des Verbindungelements 9 größer ist, als der Radius 4 der ersten Bohrung, ist sichergestellt, dass das Verbindungselements 9 bei der Montage nicht durch die Öffnung 3 des Gehäuses 2 hindurch fällt. Eine das Gehäuse 2 teilweise umgreifende Haubenform des ersten Teilsegments 10 des Verbindungselements 9 bewirkt, dass das Verbindungselement 9 teilweise in axialer Richtung fixiert ist, bis es verklebt und/oder verpresst und/oder verlötet ist und sich selbstständig zentriert.

Ein zweites Teilsegment 11 des Verbindungselements 9 besitzt einen Innendurchmesser, der dem Innendurchmesser des Außenleiters der anzuschließenden Steckverbindung plus zweimal der Wandstärke des Verbindungselements 9 entspricht, wobei der Radius 4 der ersten Bohrung bevorzugt derart gewählt ist, dass das zweite Teilsegment 11 formschlüssig an einer Innenfläche 12 des Gehäuses 2 anliegt.

Ein drittes Teilsegment 13 des Verbindungselements 9 ist verengend, z.B. konisch ausgebildet, so dass sich das Verbindungselement 9 dadurch in seinem Durchmesser verjüngt. Die sich verengende Form des dritten Teilsegments 13 des Verbindungselements 9 bewirkt, dass das Verbindungselement 9 einerseits elastische Eigenschaften aufweist und anderseits eine optimale Anpassung bis hin zu Frequenzen von 110 GHz und mehr ermöglicht. Je nach Formgebung des Gehäuses 2 sind unter Umständen auch andere mathematisch basierte Formgebungen für das dritte Teilsegment 13 denkbar, wenn sie das Reflexionsverhalten günstig beeinflussen.

Ein viertes Teilsegment 14 des Verbindungselements 9 dient dabei als Aufnahmeelement für einen Innenleiter 15. Der Durchmesser dieses vierten Teilsegments 14 ist dabei so gewählt, dass der Innenleiter 15 in dieses einführbar ist. Das Verbindungselement 9 besteht aus einem sehr gut leitfähigen Material, bevorzugt aus Gold. Auf den Herstellungsprozess des Verbindungselements 9 wird im Weiteren noch gesondert eingegangen.

Der Innenleiter 15 ist über das Verbindungselement 9 zentriert innerhalb der Öffnung 3 des Gehäuses 2 ausgebildet. Der Innenleiter 15 der Kalibriereinheit 1 ist, je nachdem, ob die Kalibriereinheit 1 die Kalibrierstandards Leerlauf oder Kurzschluss oder Abschluss darstellt, einteilig oder mehrteilig ausgebildet.

Soll die Kalibriereinheit 1 den Kalibrierstandard Kurzschluss erfüllen, dann ist der Innenleiter 15 bevorzugt aus einem Metall einteilig ausgebildet, wobei die Oberfläche des Innenleiters 15 bevorzugt mit einem sehr gut leitfähigen Material, bevorzugt mit Gold, überzogen ist.

Fig. 1 zeigt eine zweiteilige Ausbildung des Innenleiters 15, wie er für die Kalibrierstandards Leerlauf und Abschluss aufgebaut sein kann. Der Innenleiter 15 ist aus zwei Teilsegmenten aufgebaut. Ein erstes Teilsegment 15₁ des Innenleiters 15 ist entweder als Kontaktstecker 17 oder als Kontaktbuchse 43 ausgebildet und kontaktiert ein Anschlusstor des zu kalibrierenden Netzwerkanalysators direkt oder indirekt über ein koaxiales Verbindungskabel. Zu erkennen ist, dass in dem Ausführungsbeispiel aus Fig. 1 das erste Teilsegment 15₁ des Innenleiters 15 als Kontaktstecker 17 ausgebildet ist. Der Kontaktstecker 17 des ersten Teilsegments 15₁ des Innenleiters 15 weist dabei einen kleineren Durchmesser auf, als der Innenleiter 15 selbst. Das erste Teilsegment 15₁ des Innenleiters 15 weist an dem, dem Kontaktstecker 17 abgewandtem Ende, eine Bohrung 19 auf, in die das zweite Teilsegment 15₂ des Innenleiters 15 gesteckt ist. Das zweite Teilsegment 15₂ des Innenleiters 15 ist elektrisch leitend mit dem ersten Teilsegment 15₁ des Innenleiters 15 verklebt und/oder verlötet. Der Durchmesser des Innenleiters 15 beträgt für den Fall, dass es sich bei der Steckverbindung der Kalibriereinheit 1 um eine koaxiale 1mm-Steckverbindung handelt, die für Frequenzen bis 110 GHz geeignet ist, 0,434 mm.

Das zweite Teilsegment 15₂ besteht aus einem Dielektrikum mit einer möglichst niedrigen dielektrischen Leitfähigkeit εᵣ und einer hohen Biegefestigkeit, so dass der Innenleiter 15 auch mechanischen Beanspruchungen standhält. Zirkoniumoxid weist im Gegensatz zu Aluminiumoxid zwar eine höhere Biegefestigkeit auf, allerdings ist die Permittivität εᵣ recht hoch. Ein guter Kompromiss stellt Siliziumnitrid (Si₃N₄) dar, welches gesintert oder bevorzugt gehippt eine sehr hohe Biegefestigkeit bei gleichzeitig niedriger Permittivität εᵣ aufweist.

Für den Fall, dass die Kalibriereinheit 1 den Kalibrierstandard Abschluss bildet, ist das zweite Teilsegment 15₂ des Innenleiters 15, welches als Absorber dient, mit einem Dünnschichtwiderstand oder Dickschichtwiderstand überzogen. Als Material für den Dünnschichtwiderstand eignet sich z.B. eine Nickel-Chrom-Legierung. Das zweite Teilsegment 15₂ des Innenleiters 15 ist dabei ganz oder teilweise mit dem Dünnschichtwiderstand oder dem Dickschichtwiderstand überzogen. An einer Kontaktstelle zwischen dem vierten Teilsegment 14 des Verbindungselements 9 und dem zweiten Teilsegment 15₂ des Innenleiters 15 ist das zweite Teilsegment 15₂ des Innenleiters 15 bevorzugt mit einem elektrisch sehr gut leitfähigen Material, wie z.B. Gold, überzogen.

Für den Fall, dass die Kalibriereinheit 1 den Kalibrierstandard Leerlauf bildet, kann z.B. auf den Überzug des zweiten Teilsegments 15₂ des Innenleiters 15 mit dem Dünnschichtwiderstand oder dem Dickschichtwiderstand ganz verzichtet werden. Das zweite Teilsegment 15₂ des Innenleiters 15 wird mit dem Verbindungselement 9, bzw. mit dem vierten Teilsegment 14 des Verbindungselements 9 verklebt und/oder verlötet und/oder verklemmt.

Der Innenleiter 15 wird derart weit in die Öffnung 3 des Verbindungselements 9 hineingeschoben, bis einzig der Kontaktstecker 17 aus der Öffnung 3 des Verbindungselements 9 hervorsteht. Anstelle eines Kontaktsteckers 17 kann der Innenleiter 15 an seiner nicht mit dem Verbindungselement 9 verbundenen Seite auch als

Kontaktbuchse 43 ausgebildet sein, wobei in diesem Fall die Kontaktbuchse 43 mit der Öffnung des Verbindungselements 9 bündig abschließt. Das Verbindungselement 9 besteht dabei aus einem elektrisch leitfähigen Material und verbindet den Innenleiter 15 elektrisch leitend mit dem Gehäuse 2.

Fig. 2A zeigt einen Schnitt entlang der Längsachse 20 durch ein erfindungsgemäßes Ausführungsbeispiel des Verbindungselements 9. Gut zu erkennen sind die vier Teilsegmente 10, 11, 13, 14 die nahtlos miteinander verbunden sind und das Verbindungselement 9 bilden. Wie bereits erläutert, erlaubt das dritte Segment 13, dass der durch das Verbindungselement 9 aufgenommene Innenleiter 15 gegenüber dem Gehäuse elastisch abgestützt wird. Dadurch ist sichergestellt, dass der Innenleiter 15 auch bei mehrmaligem An- und Abschrauben der Kalibriereinheit 1 an ein Anschlusstor des Netzwerkanalysators oder an eine koaxiale Verbindungsleitung zum Netzwerkanalysator stets zentriert innerhalb der Öffnung 3 des Gehäuses 2 ausgerichtet ist, so dass die gewünschten Eigenschaften der Kalibriereinheit 1 auch für hohe Frequenzen zuverlässig erhalten bleiben. Dies gilt auch für den Fall, dass die Kalibriereinheit 1 versehentlich zu Boden fällt. Fig. 2B zeigt einen Schnitt entlang der Längsachse 20 durch einen Formstempel 21 eines Ausführungsbeispiels des erfindungsgemäßen Verbindungselements 9. Damit die Kalibriereinheit 1 die verschiedenen Kalibrierstandards für Frequenzen bis zu 110 GHz optimal abbildet, muss das Verbindungselement 9, welches einerseits für die optimale Anpassung sorgt und andererseits der Kalibriereinheit 1 eine ausreichende mechanische Stabilität gibt, sehr genau gefertigt werden. Hierzu wird der Formstempel 21 bevorzugt aus Aluminium gedreht. Dieser Formstempel 21 ist in Fig. 2B zu erkennen. Anschließend wird der Formstempel 21 in einem Galvanisierungsverfahren mit einem sehr gut elektrisch leitfähigen Material, wie z.B. Gold, überzogen. Die Wandstärke des Verbindungselements 9 kann dabei beliebig im Bereich einiger zig Mikrometer sehr präzise eingestellt werden. Die Wandstärke des Verbindungselements 9 wird dabei so gewählt, dass der Innenleiter 15 der Kalibriereinheit 1 im Kleinen elastisch beweglich ist und dadurch ein Bruch des Innenleiters 15, bzw. des zweiten Teilsegments 15₂ des Innenleiters 15 vermieden wird.

Sobald die richtige Wandstärke erreicht ist, kann das Verbindungselement 9 von dem Formstempel 21 abgezogen werden. Bevorzugt wird allerdings der z.B. aus Aluminium bestehende Formstempel 21 weggeätzt, so dass einzig das Verbindungselement 9 erhalten bleibt. Dies kann z.B. durch Verwendung von Natronlauge erreicht werden. Dadurch ist sichergestellt, dass die gewünschte Form des Verbindungselements 9 erhalten bleibt. Durch die bevorzugt konische Form des dritten Teilsegments 13 wird erreicht, dass eine Kalibriereinheit 1, die den Kalibrierstandard Abschluss bildet, über einen weiten Frequenzbereich ein optimales Dämpfungsverhalten zeigt. Die Vertiefung 22 am Ende des Formstempels 21 sorgt dafür, dass im vierten Teilsegment 14 des Verbindungselements ein nach innen verlaufender Kegel entsteht. Dieser dient als Zentrierhilfe für eine Bohrung, um nach dem Galvanisierungsschritt den späteren Ätzprozess zu beschleunigen.

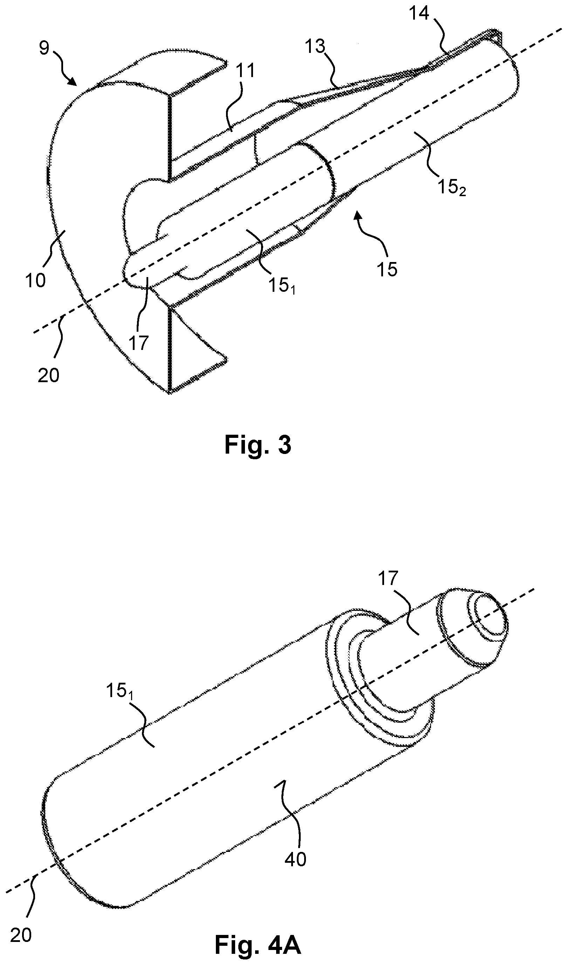

Fig. 3 zeigt einen Schnitt entlang der Längsachse 20 durch ein Ausführungsbeispiel des erfindungsgemäßen Verbindungselements 9 in einer perspektivischen Ansicht. Das erste Teilsegment 10 des Verbindungselements 9 weist dabei eine Haubenform wie in Fig. 1 auf. Eine planare flanschförmige Ausbildung ist aber ebenfalls möglich. Außerdem sind die weiteren Teilsegmente 11, 13, 14 gezeigt, wobei der Innenleiter 15 mit dem vierten Teilsegment 14 verklebt und/oder verlötet und/oder verklemmt ist.

Fig. 4A zeigt eine räumliche Darstellung eines Ausführungsbeispiels eines erfindungsgemäßen Innenleiters 15 mit seinem Kontaktstecker 17. Bei dem dargestellten Innenleiter 15 kann es sich auch nur um das erste Segment 15₁ des Innenleiters 15 aus Fig. 1 handeln. Der Innenleiter 15 und sein Kontaktstecker 17 werden in einem Drehprozess hergestellt und anschließend durch Sputtern oder Galvanisieren mit einer sehr gut elektrisch leitfähigen Schicht überzogen. Der Sputter- oder Galvanisierungsprozess wird dabei so eingestellt, dass sich der gewünschte Durchmesser für den Innenleiter 15 ergibt.

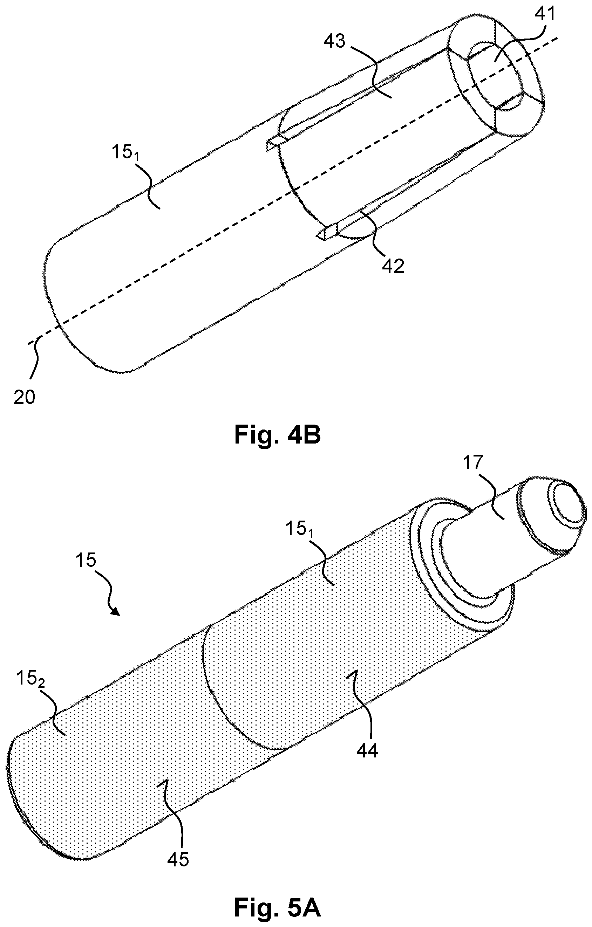

Fig. 4B zeigt eine räumliche Darstellung eines Ausführungsbeispiels eines erfindungsgemäßen Innenleiters 15 mit einer Kontaktbuchse 43, bei dem es sich ebenfalls nur um das erste Segment 15₁ des Innenleiters 15 aus Fig. 1 handeln kann und der ebenfalls bevorzugt in einem Drehprozess hergestellt wird. Anschließend wird in einem Bohrprozess ein Bohrloch 41 in den Innenleiter 15 gebohrt und in einem anschließenden Fräsprozess zumindest ein Längsschlitz 42 in die Kontaktbuchse 43 gefräst. Schließlich wird die Kontaktbuchse 43, wie in Fig. 4B gezeigt, konisch zusammengepresst, so dass sich die Kontaktbuchse 43 bei Kontaktierung mit einem Steckkontakt wie in Fig. 4A derart weitet, dass der Innenleiter 15 einen Durchmesser von 0,434 mm aufweist. Der mit der Kontaktbuchse 43 versehene geschlitzte und in seinem Durchmesser etwas verkleinerte Innenleiter 15 wird, wie auch der mit einem Steckkontakt versehene Innenleiter 15, in einem Sputter- oder Galvanisierungsprozess mit einer sehr gut elektrisch leitfähigen Schicht überzogen, wobei der Prozess so eingestellt ist, dass sich der gewünschte Durchmesser des Innenleiters 15 ergibt.

Fig. 5A zeigt eine räumliche Darstellung eines Ausführungsbeispiels eines erfindungsgemäßen Innenleiters 15, wie er z.B. für den Kalibrierstandard Kurzschluss verwendet werden kann. Der Innenleiter 15 besteht in diesem Ausführungsbeispiel aus einem ersten Teilsegment 15₁ und einem zweiten Teilsegment 15₂, deren Oberflächen 44 und 45 jeweils mit einer sehr gut elektrisch leitfähigen Schicht überzogen sind. Bevorzugt ist der Innenleiter 15 für den Kalibrierstandard Kurzschluss allerdings einteilig ausgebildet, so dass sich keinerlei Störstelle zwischen dem ersten Teilsegment 15₁ und dem zweiten Teilsegment 15₂ ausbilden kann.

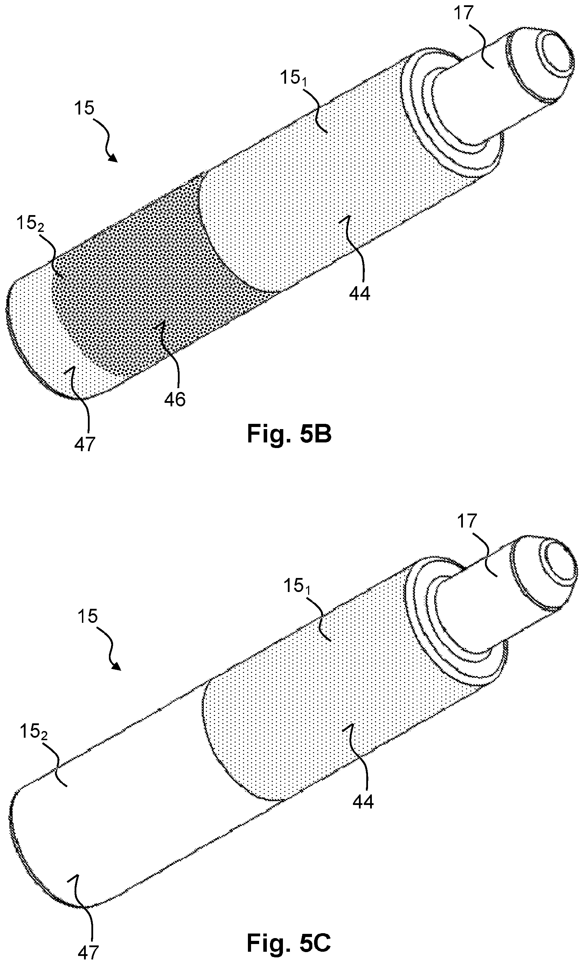

Fig. 5B zeigt eine räumliche Darstellung eines Ausführungsbeispiels des erfindungsgemäßen Innenleiters 15, wie er für den Kalibrierstandard Abschluss verwendet werden kann. Der Innenleiter 15 ist dabei zweiteilig ausbildet und weist ein erstes Teilsegment 15₁ und ein zweites Teilsegment 15₂ auf. Zumindest die Oberfläche 44 des ersten Teilsegments 15₁ ist dabei mit einem elektrisch sehr gut leitenden Material, bevorzugt Gold, beschichtet. Das zweite Teilsegment 15₂, welches aus einem Dielektrikum besteht, ist bevorzugt an seiner Oberfläche 47, die elektrisch leitend mit dem vierten Teilsegment 14 des Verbindungselements 9 verbunden ist, mit einer elektrisch leitfähigen Schicht, z.B. aus Gold versehen. Die Oberfläche 47 nimmt dabei nur einen Teil der Oberfläche des zweiten Teilsegments 15₂ des Innenleiters 15 ein. Die restliche Oberfläche 46 des zweiten Teilsegments 15₂ des Innenleiters 15 ist mit einem Dünnschichtwiderstand oder einem Dickschichtwiderstand überzogen, dessen Dicke derart gewählt ist, dass der Innenleiter 15 mit seinem ersten Teilsegment 15₁ und seinem zweiten Teilsegment 15₂ und dem Verbindungselement 9 sowie dem Gehäuse 2 einen Widerstandswert z.B. etwas unterhalb von 50 Ohm erreicht. Durch einen Trimmvorgang mit Hilfe eines Lasers wird dann der gewünschte Widerstandswert von z.B. exakt 50 Ohm eingestellt.

Fig. 5C zeigt eine räumliche Darstellung eines Ausführungsbeispiels eines erfindungsgemäßen Innenleiters 15, wie er für den Kalibrierstandard Leerlauf verwendet werden kann. Der Innenleiter 15 ist mit seinem ersten Teilsegment 15₁ und seinem zweiten Teilsegment 15₂ dabei zweiteilig ausgebildet. Das erste Teilsegment 15₁ des Innenleiters 15 ist dabei zumindest an seiner Oberfläche 44 mit einer elektrisch leitfähigen Schicht überzogen. Das zweite Teilsegment 15₂ ist bevorzugt an seiner Oberfläche 47, die mechanisch direkt mit dem vierten Teilsegment 14 des Verbindungselements 9 verbunden ist, mit keiner oder mit einer elektrisch nicht leitenden Schicht überzogen.

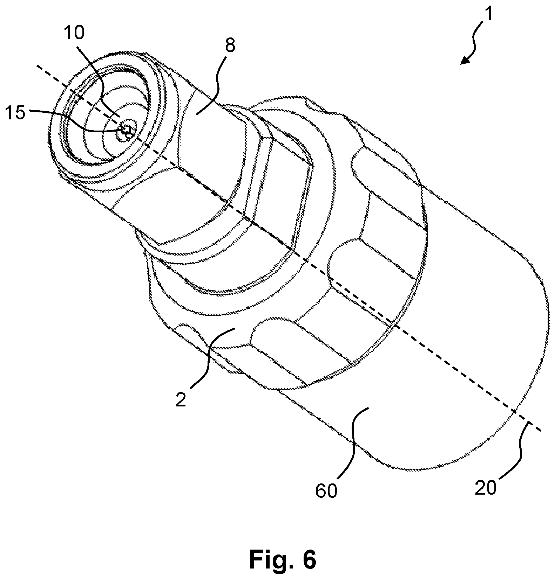

Fig. 6 zeigt eine räumliche Darstellung eines Ausführungsbeispiels der gesamten erfindungsgemäßen Kalibriereinheit 1 als Stecker im montierten Zustand. Zu erkennen ist das Gehäuse 2 mit dem Überwurf 8. In dem Überwurf 8 ist ferner noch ein Gewinde ausgebildet, durch welches die Kalibriereinheit 1 mit einem Anschlusstor des zu kalibrierenden Netzwerkanalysators verschraubt wird. Weiterhin ist das erste Segment 10 des Verbindungselements 9 zu erkennen. Dazwischen ist der mit einem Kontaktstecker 17 versehene Innenleiter 15 ausgebildet. Eine Gehäusekappe 60 ist auf der, der Steckverbindung abgewandten Seite des Gehäuses 2, angebracht. Prinzipiell kann das in Fig. 6 gezeigte Ausführungsbeispiel der gesamten erfindungsgemäßen Kalibriereinheit 1 auch als Buchse ausgeführt werden. Dazu erhält der Innenleiter 15 eine Kontaktbuchse 43. Ferner entfällt der Überwurf 8 und das Gehäuse 2 erhält ein zusätzliches Gewinde.

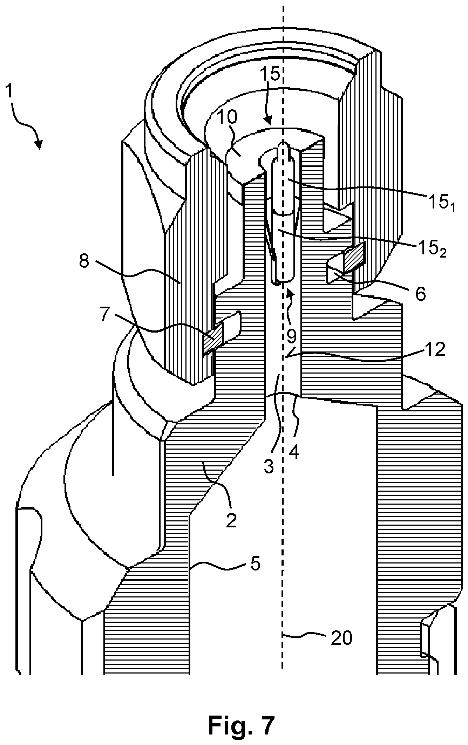

Fig. 7 zeigt eine geschnittene räumliche Darstellung eines Ausführungsbeispiels der erfindungsgemäßen Kalibriereinheit 1 entlang der Längsachse 20. Zur besseren Übersicht ist der geschnittene Innenleiter 15 nicht schraffiert abgebildet. Dargestellt sind der Überwurf 8 mit seinem Gewinde, der Sprengring 7, die Nut 6 und das Gehäuse 2. Bei dem Gehäuse 2 sind die unterschiedlichen Bohrradien 4 und 5 gut erkennbar. Der zweiteilig ausgebildete Innenleiter 15 ist zentriert in der Öffnung 3 des Gehäuses 2 ausgebildet und fest mit dem Verbindungselement 9 verklemmt und/oder verlötet und/oder verklebt. Das Verbindungselement 9 ist mit seinem haubenförmig ausgebildeten ersten Segment 10 fest mit dem Gehäuse 2 verklebt und/oder verlötet.

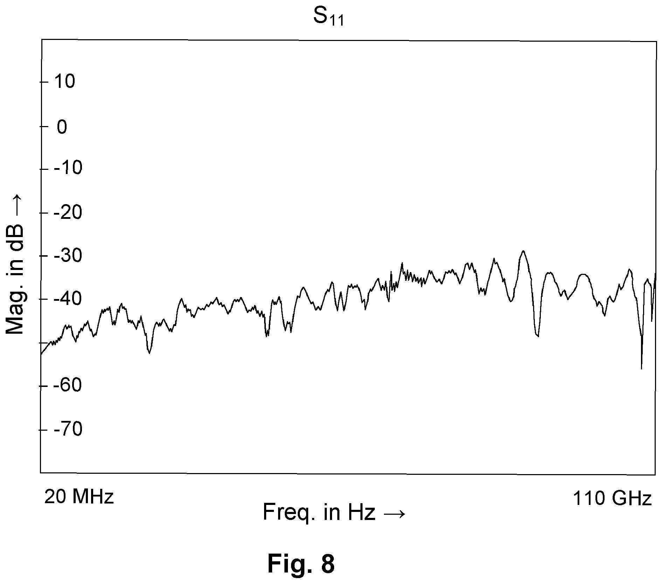

Fig. 8 zeigt den Betrag des Streuparameters S11 in logarithmischer Darstellung, also die Reflexionsdämpfung über der Frequenz für ein Ausführungsbeispiel der erfindungsgemäßen Kalibriereinheit 1. Die Kalibrierienheit 1 stellt in diesem Ausführungsbeispiel den Kalibrierstandard Abschluss dar. Zu erkennen ist, dass die Reflexionsdämpfung im Frequenzbereich von 20 MHz bis zu 110 GHz maximal einen Wert von z.B. -30 dB annimmt. Die Frequenz ist auf der Abszisse linear von 20 MHz bis 110 GHz aufgetragen. Für den Kalibrierstandard Abschluss ist dies ein sehr guter Wert, der eine sicherere Unterscheidung, also einen großen Dynamikbereich, zwischen dem Kalibrierstandard Abschluss und den Kalibrierstandards Leerlauf und Kurzschluss gewährleistet.

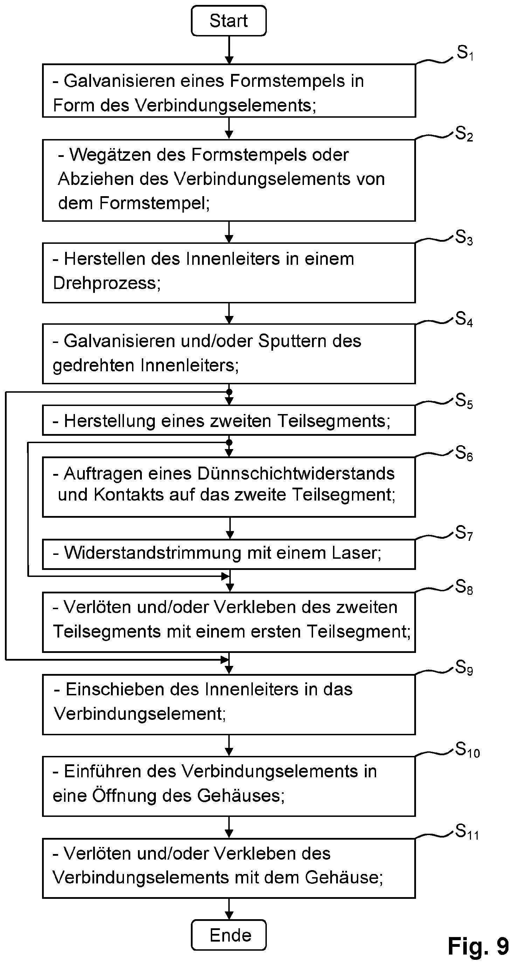

Fig. 9 zeigt ein Flussdiagramm des Verfahrens für die Herstellung der erfindungsgemäßen Kalibriereinheit 1 für das Ausführungsbeispiels eines Abschlusses. Für die Ausführungsbeispiele Kurzschluss, bzw. Leerlauf werden die Verfahrensschritte S₅ bis S₈ bzw. S₆ bis S₇ bevorzugt ausgelassen. In einem ersten Verfahrensschritt S₁ wird ein vorgefertigter Formstempel 21 bestehend aus einem Grundmaterial, bevorzugt aus Aluminium, in einem Galvanisierungsverfahren bevorzugt mit einer Goldschicht mit einstellbarer Wandstärke galvanisiert. Bei dem Formstempel 21 handelt es sich auch um eine Negativform des Verbindungselements 9. Vor dem Galvanisierungsprozess kann auf den Formstempel 21 auch eine dünne Schicht, die bevorzugt aus Gold besteht, durch Sputtern aufgetragen werden.

In einem zweiten Verfahrensschritt S₂ wird der Formstempel 21 weggeätzt oder das durch den Galvanisierungsprozess entstandene Verbindungselement 9 von dem Formstempel 21 abgezogen.

In einem dritten Verfahrensschritt S₃ wird der Innenleiter 15 oder nur ein erstes Teilsegment 15₁ in einem Drehprozess aus einem nach Möglichkeit hartem Metall hergestellt.

In einem vierten Verfahrensschritt S₄ wird eine sehr gut leitfähige Deckschicht auf den Innenleiter 15 oder nur ein erstes Teilsegment 15₁ durch Galvanisieren und/oder Sputtern aufgetragen. Bevorzugt handelt es sich bei der leitfähigen Deckschicht um eine Goldschicht.

Für den Fall, dass die Kalibriereinheit 1 die Kalibrierstandards Leerlauf oder Abschluss bilden soll, wird in einem fünften Verfahrensschritt S₅ ein zweites Teilsegment 15₂ des Innenleiters 15, bevorzugt aus einem Dielektrikum, wie z.B. gesintertem oder gehipptem Silizium-Nitrid (Si₃N₄), hergestellt.

Für den Fall, dass die Kalibriereinheit 1 den Kalibrierstandard Abschluss bilden soll, wird in einem sechsten Verfahrensschritt S₆ ein Dünnschichtwiderstand oder ein Dickschichtwiderstand auf das zweite Teilsegment 15₂ des Innenleiters 15 aufgetragen. An einer Kontaktstelle zwischen dem vierten Teilsegment 14 des Verbindungselements 9 und dem zweiten Teilsegment 15₂ des Innenleiters 15 ist das zweite Teilsegment 15₂ des Innenleiters 15 bevorzugt mit einem elektrisch sehr gut leitfähigen Material, wie z.B. Gold, überzogen.

Für den Fall, dass die Kalibriereinheit 1 den Kalibrierstandard Abschluss bilden soll, wird in einem siebten Verfahrensschritt S₇ der Dünnschichtwiderstand oder der Dickschichtwiderstand des Teilsegments 15₂ auf den gewünschten Wert von z.B. exakt 50 Ohm mit Hilfe eines Lasers getrimmt.

Für den Fall, dass die Kalibriereinheit 1 die Kalibrierstandards Leerlauf oder Abschluss bilden soll, wird in einem achten Verfahrensschritt S₈ das zweite Teilsegment 15₂ des Innenleiters 15 mit einem ersten Teilsegment 15₁ des Innenleiters 15 elektrisch leitend verlötet und/oder verklebt.

In einem neunten Verfahrensschritt S₉ wird sowohl der einteilige ausgebildete Innenleiter 15 als auch der mehrteilig ausgebildete Innenleiter 15 mit seinem ersten Segment 15₁ und seinem zweiten Segment 15₂ in das Verbindungselement 9 derart eingeschoben, dass der Innenleiter 15 zentriert in dem Verbindungselement 9 angeordnet ist und mit seinem dem Anschlussstecker abgewandten Ende fest mit dem Verbindungselement 9 verlötet und/oder verklebt und/oder verklemmt ist. Der Innenleiter 15 wird dabei soweit in das Verbindungselement 9 eingeschoben, dass einzig der Kontaktstecker 17 aus dem Verbindungselement 9 hervorsteht oder die Kontaktbuchse 43 bündig mit dem Verbindungselement 9 abschließt.

In einem zehnten Verfahrensschritt S₁₀ wird das Verbindungselement 9 in eine Öffnung 3 des Gehäuses 2 der Kalibriereinheit 1 eingeführt.

In einem elften Verfahrensschritt S₁₁ wird das Verbindungelement 9 an seinem ersten Segment 10 mit dem Gehäuse elektrisch leitend verlötet und/oder verklebt.

Im Rahmen der Erfindung sind alle beschriebenen und/oder gezeichneten Merkmale beliebig miteinander kombinierbar. Die Kalibriereinheit 1 eignet sich für sämtliche koaxiale Steckverbindungen und für alle Arten von Messgeräten die über koaxiale Anschlusstore verfügen. Durch Verkleinern der Abmessungen ist die Kalibriereinheit auch für Frequenzen oberhalb von 110 GHz einsetzbar.

Die erfindungsgemäße Kalibriereinheit 1 kann sowohl als Stecker und auch als Buchse ausgeführt sein. Bei Ausführung als Buchse weist der Innenleiter 15 eine Kontaktbuchse 43 auf. Dabei entfällt der Überwurf 8, die Nut 6 und der Sprengring 7 an der Kalibriereinheit 1 und das Gehäuse 2 erhält ein zusätzliches Gewinde.

## Patentansprüche

1. Kalibriereinheit (1) für ein Messgerät zum Verbinden mit einer koaxial ausgeführten Steckverbindung, aufweisend ein Gehäuse (2) und einen Innenleiter (15), wobei der Innenleiter (15) zentriert innerhalb einer Öffnung (3) des Gehäuses (2) ausgebildet ist,
wobei die Kalibriereinheit (1) ein Verbindungselement (9) aufweist,
wobei das Verbindungselement (9) in die Öffnung (3) des Gehäuses (2) eingesetzt ist und
wobei das Verbindungselement (9) elastisch ausgebildet ist,
wobei das Verbindungselement (9) den Innenleiter (15) aufnimmt,
wobei das Verbindungselement (9) den Innenleiter (15) gegenüber dem Gehäuse (2) elastisch abstützt,
wobei Verbindungselement (9) trichterförmig ausgebildet ist und mehrere nahtlos zusammenhängende Teilsegmente (10, 11, 13, 14) umfasst,
wobei ein erstes Teilsegment (10) des Verbindungselements (9) als Flansch oder Haube ausgebildet ist und mit dem Gehäuse (2) elektrisch leitend verklebt und/oder verpresst und/oder verlötet ist,
wobei das Gehäuse (2) elektrisch leitfähig ist oder zumindest mit einer elektrisch leitfähigen Schicht überzogen ist und
wobei das Verbindungselement (9) aus einem elektrisch leitfähigen Material besteht.

2. Kalibriereinheit nach Anspruch 1,
**dadurch gekennzeichnet,**
**dass** ein zweites Teilsegment (11) des Verbindungselements (9) einen Innendurchmesser aufweist, der dem Innendurchmesser des Außenleiters der anzuschließenden Steckverbindung entspricht.

3. Kalibriereinheit nach Anspruch 1 oder 2,
**dadurch gekennzeichnet,**
**dass** ein drittes Teilsegment (13) des Verbindungselements (9) verengend, insbesondere konisch ausgebildet ist und das Verbindungselement (9) dadurch in seinem Durchmesser verjüngt.

4. Kalibriereinheit nach einem der Ansprüche 1 bis 3,
**dadurch gekennzeichnet,**
**dass** ein viertes Teilsegment (14) des Verbindungselements (9) als Aufnahmeelement für den Innenleiter (15) dient.

5. Kalibriereinheit nach einem der vorherigen Ansprüche,
**dadurch gekennzeichnet,**
**dass** die Kalibriereinheit (1) für die Lastzustände Leerlauf oder Kurzschluss oder Abschluss verwendbar ist.

6. Kalibriereinheit nach Anspruch 5,
**dadurch gekennzeichnet,**
**dass** der Innenleiter (1) im Falle der Lastzustände Leerlauf und Abschluss aus zumindest zwei Teilsegmenten (15₁, 15₂) besteht, wobei ein zweites Teilsegment (15₂) des Innenleiters (15) aus einem Dielektrikum besteht, welches im Falle des Lastzustands Abschluss abschnittsweise mit einem Dünnschichtwiderstand oder einem Dickschichtwiderstand und einem elektrisch leitfähigen Material überzogen ist.

7. Kalibriereinheit nach Anspruch 6,
**dadurch gekennzeichnet,**
**dass** ein erstes Teilsegment (15₁) des Innenleiters (15) eine Bohrung (19) aufweist, in die das zweite Teilsegment (15₂) des Innenleiters (15) gesteckt ist und wobei beide Teilsegmente (15₁, 15₂) des Innenleiters (15) miteinander elektrisch verbindbar sind.

8. Kalibriereinheit nach Anspruch 6 oder 7,
**dadurch gekennzeichnet,**
**dass** ein nicht mit dem ersten Teilsegment (15₁) des Innenleiters (15) verbundenes Ende des zweiten Teilsegments (15₂) des Innenleiters (15) mit dem Verbindungselement (9) verklebt und/oder verlötet und/oder verklemmt ist.

9. Kalibriereinheit nach einem der vorherigen Ansprüche,
**dadurch gekennzeichnet,**
**dass** das Verbindungselement (9) aus einem elektrisch leitfähigen Material besteht und den Innenleiter (15) mit dem Gehäuse (2) elektrisch leitend verbindet.

10. Kalibriereinheit nach einem der vorherigen Ansprüche,
**dadurch gekennzeichnet,**
**dass** der Innenleiter (15) an seiner nicht mit dem Verbindungselement (9) verbundenen Seite als Kontaktstecker (17) oder als Kontaktbuchse (43) ausgebildet ist.

11. Kalibriereinheit nach Anspruch 10,
**dadurch gekennzeichnet,**
**dass** die als Kontaktbuchse (43) ausgebildete Seite des Innenleiters (15) geschlitzt und in ihrem Durchmesser konisch ausgebildet ist.

12. Verfahren zur Herstellung der Kalibriereinheit (1) für ein Messgerät zum Verbinden mit einer koaxialen Steckverbindung, wobei die Kalibriereinheit (1) ein Gehäuse (2) und einen Innenleiter (15) aufweist, wobei der Innenleiter (15) durch ein elastisches Verbindungselement (9) zentriert innerhalb einer Öffnung (3) des Gehäuses (2) ausgebildet ist mit den folgenden Verfahrensschritten:
- Galvanisieren (S₁) eines Formstempels (21) welcher eine Negativform des Verbindungselements (9) darstellt;
- Wegätzen (S₂) des Formstempels (21) oder Abziehen des Verbindungselements (9) von dem Formstempel (21).

13. Verfahren nach Anspruch 12,
**gekennzeichnet durch**,
folgende Verfahrensschritte:
- Herstellen (S₃) des Innenleiters (15) oder eines ersten Teilsegments (15₁) des Innenleiters (15) in einem Drehprozess;
- Galvanisieren (S₄) und/oder Sputtern des gedrehten Innenleiters (15) oder des gedrehten ersten Teilsegments (15₁) des Innenleiters (15);

14. Verfahren nach Anspruch 13,
**gekennzeichnet durch,**
folgende Verfahrensschritte:
- Pressen oder Sintern oder Drehen (S₅) eines zweiten Teilsegments (15₂) des Innenleiters (15) mit dielektrischen Eigenschaften;
- Abschnittsweises Auftragen (S₆) eines Dünnschichtwiderstands oder eines Dickschichtwiderstands und einer elektrisch leitfähigen Schicht auf das zweite Teilsegment (15₂);
- Trimmen (S₇) des Dünnschichtwiderstands oder des Dickschichtwiderstands mit Hilfe eines Lasers;
- Verlöten (S₈) oder Verkleben des zweiten Teilsegments (15₂) des Innenleiters (15) mit dem ersten Teilsegment (15₁) des Innenleiters (15).

15. Verfahren nach Anspruch 14,
**gekennzeichnet durch,**
folgende Verfahrensschritte:
- Einschieben (S₉) des Innenleiters (15) oder des ersten Teilsegments (15₁) und des zweiten Teilsegments (15₂) des Innenleiters (15) in das Verbindungselement (9);
- Einführen (S₁₀) des Verbindungselements (9) in die Öffnung (3) des Gehäuses (2);
- Verlöten (S₁₁) oder Verkleben des Verbindungselements (9) mit dem Gehäuse (2).

16. Verfahren nach einem der Ansprüche 12 bis 15,
**dadurch gekennzeichnet,**
**dass** das Verbindungselement (9) zumindest ein konisches sich verengendes Teilsegment (13) aufweist und elastisch ausgebildet ist.

17. Verfahren nach einem der Ansprüche 12 bis 16,
**dadurch gekennzeichnet,**
**dass** das Verbindungselement (9) den Innenleiter (15) elektrisch leitend mit dem Gehäuse (2) verbindet.

## Claims

1. Calibrating unit (1) for a measuring device to be connected with a coaxial plug-type connector, having a housing (2) and an inner conductor (15), wherein the inner conductor (15) is formed so as to be centred within an opening (3) of the housing (2),
wherein the calibrating unit (1) has a connecting element (9),
wherein the connecting element (9) is inserted in the opening (3) of the housing (2) and
wherein the connecting element (9) is formed so as to be elastic,
wherein the connecting element (9) accommodates the inner conductor (15),
wherein the connecting element (9) supports the inner conductor (15) elastically relative to the housing (2),
wherein the connecting element (9) is formed so as to be funnel-shaped and comprises a plurality of seamlessly connected part segments (10, 11, 13, 14),
wherein a first part segment (10) of the connecting element (9) is embodied in the form of a flange or hood and is glued and/or pressed and/or soldered in electrically conducting manner to the housing (2),
wherein the housing (2) is electrically conductive or at least covered with an electrically conductive coating and
wherein the connecting element (9) is composed of an electrically conductive material.

2. Calibrating unit according to claim 1,
**characterised in that**
a second part segment (11) of the connecting element (9) has an inside diameter which corresponds to the inside diameter of the outer conductor of the plug-type connector to be connected.

3. Calibrating unit according to claim 1 or 2,
**characterised in that**
a third part segment (13) of the connecting element (9) is formed so as to narrow, in particular so as to be conical, and the connecting element (9) thereby tapers in its diameter.

4. Calibrating unit according to one of claims 1 to 3,
**characterised in that**
a fourth part segment (14) of the connecting element (9) serves as an accommodating element for the inner conductor (15).

5. Calibrating unit according to one of the preceding claims,
**characterised in that**
the calibrating unit (1) can be used for the "open", "short" or "match" load states.

6. Calibrating unit according to claim 5,
**characterised in that**
in the case of the "open" and "match" load states the inner conductor (1) consists of at least two part segments (15₁, 15₂), with a second part segment (15₂) of the inner conductor (15) being composed of a dielectric which in the case of the "match" load state is coated in sections with a thin-film resistor or a thick-film resistor and an electrically conductive material.

7. Calibrating unit according to claim 6,
**characterised in that**
a first part segment (15₁) of the inner conductor (15) has a bore (19) into which the second part segment (15₂) of the inner conductor (15) is inserted and wherein both part segments (15₁, 15₂) of the inner conductor (15) can be connected with one another electrically.

8. Calibrating unit according to claim 6 or 7,
**characterised in that**
an end of the second part segment (15₂) of the inner conductor (15) not connected with the first part segment (15₁) of the inner conductor (15) is glued and/or soldered and/or clamped to the connecting element (9).

9. Calibrating unit according to one of the preceding claims,
**characterised in that**
the connecting element (9) is composed of an electrically conductive material and connects the inner conductor (15) with the housing (2) in an electrically conducting manner.

10. Calibrating unit according to one of the preceding claims,
**characterised in that**
at its end not connected with the connecting element (9) the inner conductor (15) is embodied in the form of a contact plug (17) or a contact socket (43).

11. Calibrating unit according to claim 10,
**characterised in that**
the end of the inner conductor (15) embodied in the form of a contact socket is slotted and embodied so as to be conical in its diameter.

12. Method for manufacturing the calibrating unit (1) for a measuring device to be connected with a coaxial plug-type connector, wherein the calibrating unit (1) has a housing (2) and an inner conductor (15),
wherein the inner conductor (15) is formed so as to be centred within an opening (3) of the housing (2) by an elastic connecting element (9),
with the following method steps:
- electroplating (S₁) of a forming template (21) which represents a negative shape of the connecting element (9) ;
- etching away (S₂) of the forming template (21) or peeling or detaching of the connecting element (9) from the forming template (21).

13. Method according to claim 12,
**characterised by**
the following method steps:
- manufacturing (S₃) of the inner conductor (15) or of a first part segment (15₁) of the inner conductor (15) in a turning process;
- electroplating (S₄) and/or sputtering of the turned inner conductor (15) or of the turned first part segment (15₁) of the inner conductor (15).

14. Method according to claim 13,
**characterised by**
the following method steps:
- pressing or sintering or turning (S₅) of a second part segment (15₂) of the inner conductor (15) with dielectric properties;
- sectional application (S₆) of a thin-film resistor or of a thick-film resistor and an electrically conductive coating to the second part segment (15₂);
- trimming (S₇) of the thin-film resistor or of the thick-film resistor with the aid of a laser;
- soldering (S₈) or gluing of the second part segment (15₂) of the inner conductor (15) with the first part segment (15₁) of the inner conductor (15).

15. Method according to claim 14,
**characterised by**
the following method steps:
- insertion (S₉) of the inner conductor (15) or of the first part segment (15₁) and of the second part segment (15₂) of the inner conductor (15) into the connecting element (9);
- introduction (S₁₀) of the connecting element (9) into the opening (3) of the housing (2);
- soldering (S₁₁) or gluing of the connecting element (9) with the housing (2).

16. Method according to one of claims 12 to 15,
**characterised in that**
the connecting element (9) has at least one conical narrowing part segment (13) and is embodied so as to be elastic.

17. Method according to one of claims 12 to 16,
**characterised in that**
the connecting element (9) connects the inner conductor (15) with the housing (2) in electrically conducting manner.

## Revendications

1. Unité d'étalonnage (1) pour un appareil de mesure et destinée à être reliée à une connexion enfichable de configuration coaxiale, comprenant un boitier (2) et un conducteur intérieur (15), le conducteur intérieur (15) étant réalisé de manière centrée à l'intérieur d'une ouverture (3) du boitier (2),
l'unité d'étalonnage (1) comportant un élément de liaison (9),
l'élément de liaison (9) étant inséré dans l'ouverture (3) du boitier (2), et
l'élément de liaison (9) étant de configuration élastique, l'élément de liaison (9) accueillant le conducteur intérieur (15),
l'élément de liaison (9) supportant le conducteur intérieur (15) de manière élastique par rapport au boitier (2),
l'élément de liaison (9) étant réalisé en forme d'entonnoir et comportant plusieurs segments partiels (10, 11, 13, 14) réunis sans jointure,
un premier segment partiel (10) de l'élément de liaison (9) étant réalisé sous forme de flasque ou de chapeau, et est assemblé de manière électriquement conductrice au boitier (2), par collage et/ou par montage à force et/ou par brasage,
le boitier (2) étant électriquement conducteur ou au moins revêtu d'une couche électriquement conductrice,
et l'élément de liaison (9) étant réalisé en un matériau électriquement conducteur.

2. Unité d'étalonnage selon la revendication 1,
**caractérisée**
**en ce qu'**un deuxième segment partiel (11) de l'élément de liaison (9) présente un diamètre intérieur, qui correspond au diamètre intérieur du conducteur extérieur de la connexion enfichable à raccorder.

3. Unité d'étalonnage selon la revendication 1 ou la revendication 2,
**caractérisée**
**en ce qu'**un troisième segment partiel (13) de l'élément de liaison (9) est d'une forme allant en se rétrécissant, notamment d'une forme conique, et l'élément de liaison (9) se rétrécit ainsi quant à son diamètre.

4. Unité d'étalonnage selon l'une des revendications 1 à 3,
**caractérisée**
**en ce qu'**un quatrième segment partiel (14) de l'élément de liaison (9) sert d'élément d'accueil pour le conducteur intérieur (15).

5. Unité d'étalonnage selon l'une des revendications précédentes,
**caractérisée**
**en ce que** l'unité d'étalonnage (1) peut être utilisée pour les états de charge correspondant au mode circuit ouvert ou au mode court-circuit ou bien encore au mode charge adaptée.

6. Unité d'étalonnage selon la revendication 5,
**caractérisée**
**en ce que** le conducteur intérieur (1) est constitué, dans le cas des états de charge correspondant au mode circuit ouvert et au mode charge adaptée, d'au moins deux segments partiels (15₁, 15₂), un deuxième segment partiel (15₂) du conducteur intérieur (15) étant constitué d'un diélectrique qui, dans le cas de l'état de charge correspondant au mode charge adaptée, est revêtu par secteurs, d'une résistance à couche mince ou d'une résistance à couche épaisse et d'un matériau électriquement conducteur.

7. Unité d'étalonnage selon la revendication 6,
**caractérisée**
**en ce qu'**un premier segment partiel (15₁) du conducteur intérieur (15) présente un alésage (19) dans lequel est enfiché le deuxième segment partiel (15₂) du conducteur intérieur (15), et les deux segments partiels (15₁, 15₂) du conducteur intérieur (15) peuvent être reliés électriquement l'un à l'autre.

8. Unité d'étalonnage selon la revendication 6 ou la revendication 7,
**caractérisée**
**en ce qu'**une extrémité du deuxième segment partiel (15₂) du conducteur intérieur (15), qui n'est pas reliée au premier segment partiel (15₁) du conducteur intérieur (15), est collée et/ou brasée et/ou montée à force avec l'élément de liaison (9).

9. Unité d'étalonnage selon l'une des revendications précédentes,
**caractérisée**
**en ce que** l'élément de liaison (9) est réalisé en un matériau électriquement conducteur, et relie le conducteur intérieur (15) au boitier (2) de manière électriquement conductrice.

10. Unité d'étalonnage selon l'une des revendications précédentes,
**caractérisée**
**en ce que** le conducteur intérieur (15) est réalisé, au niveau de son côté non relié à l'élément de liaison (9), sous forme de fiche de contact mâle (17) ou de fiche de contact femelle (43).

11. Unité d'étalonnage selon la revendication 10,
**caractérisée**
**en ce que** le côté du conducteur intérieur (15) réalisé sous la forme de fiche de contact femelle (43), est fendu et est de configuration conique quant à son diamètre.

12. Procédé de fabrication de l'unité d'étalonnage (1) pour un appareil de mesure et destinée à être reliée à une connexion enfichable de configuration coaxiale, l'unité d'étalonnage (1) comprenant un boitier (2) et un conducteur intérieur (15), et le conducteur intérieur (15) étant réalisé de manière centrée à l'intérieur d'une ouverture (3) du boitier (2) par l'intermédiaire d'un élément de liaison (9) élastique, le procédé comprenant les étapes suivantes :
- dépôt électrolytique (S₁) sur un mandrin de forme (21), qui représente une forme négative de l'élément de liaison (9) ;
- destruction par décapage ou attaque (S₂), du mandrin de forme (21), ou retrait de l'élément de liaison (9) du mandrin de forme (21).

13. Procédé selon la revendication 12,
**caractérisé**
**par** les étapes de procédé suivantes :
- fabrication (S₃) du conducteur intérieur (15) ou d'un premier segment partiel (15₁) du conducteur intérieur (15) au cours d'un processus de tournage ;
- dépôt électrolytique (S₄) et/ou pulvérisation sur le conducteur intérieur (15) ou bien le premier segment partiel (15₁) du conducteur intérieur (15) .

14. Procédé selon la revendication 13,
**caractérisé**
**par** les étapes de procédé suivantes :
- pressage ou frittage ou tournage (S₅) d'un deuxième segment partiel (15₂) du conducteur intérieur (15), à propriétés diélectriques ;
- application par secteurs (S₆) d'une résistance à couche mince ou d'une résistance à couche épaisse et d'une couche électriquement conductrice sur le deuxième segment partiel (15₂) ;
- ajustage ou dressage (S₇) de la résistance à couche mince ou de la résistance à couche épaisse, à l'aide d'un laser ;
- brasage (S₈) ou collage du deuxième segment partiel (15₂) du conducteur intérieur (15), avec le premier segment partiel (15₁) du conducteur intérieur (15).

15. Procédé selon la revendication 14,
**caractérisé**
**par** les étapes de procédé suivantes :
- insertion (S₉) du conducteur intérieur (15) ou bien du premier segment partiel (15₁) et du deuxième segment partiel (15₂) du conducteur intérieur (15), dans l'élément de liaison (9) ;
- introduction (S₁₀) de l'élément de liaison (9) dans l'ouverture (3) du boitier (2) ;
- brasage (S₁₁) ou collage de l'élément de liaison (9) avec le boitier (2).

16. Procédé selon l'une des revendications 12 à 15,
**caractérisé**
**en ce que** l'élément de liaison (9) présente un segment partiel (13) se rétrécissant de manière conique, et est de configuration élastique.

17. Procédé selon l'une des revendications 12 à 16,
**caractérisé**
**en ce que** l'élément de liaison (9) relie, de manière électriquement conductrice, le conducteur intérieur (15) au boitier (2).
